(19) Europäisches Patentamt
European Patent Office
Office européen des brevets

(11) Publication number: **0 230 047 B1**

(12) **EUROPEAN PATENT SPECIFICATION**

(45) Date of publication of patent specification: **27.12.91**

(51) Int. Cl.[5]: **C08K 5/00**, C08K 5/54, C08L 67/02

(21) Application number: **86117999.2**

(22) Date of filing: **23.12.86**

The file contains technical information submitted after the application was filed and not included in this specification

(54) **Flame-retardant resin composition.**

(30) Priority: **25.12.85 JP 297809/85**

(43) Date of publication of application:
**29.07.87 Bulletin 87/31**

(45) Publication of the grant of the patent:
**27.12.91 Bulletin 91/52**

(84) Designated Contracting States:
**BE DE FR GB IT NL**

(56) References cited:
**EP-A- 0 041 315**
**EP-A- 0 065 777**
**EP-A- 0 188 767**
**US-A- 4 100 075**

(73) Proprietor: **KANEGAFUCHI KAGAKU KOGYO KABUSHIKI KAISHA**
**2-4 Nakanoshima 3-chome**
**Kita-ku Osaka-shi Osaka-fu(JP)**

(72) Inventor: **Miyashita, Shunitsu**
**3-10, Shinwa-dai 3-chome Tarumi-ku**
**Kobe-shi Hyogo(JP)**
Inventor: **Mogami, Kenji**
**6-532, Maiko-dai 6-chome Tarumi-ku**
**Kobe-shi Hyogo(JP)**

(74) Representative: **Vossius & Partner**
**Siebertstrasse 4 P.O. Box 86 07 67**
**W-8000 München 86(DE)**

**EP 0 230 047 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention relates to a flame-retardant resin composition and, more specifically, it relates to a flame-retardant resin composition comprising a thermoplastic polyester which is excellent in mechanical property and thermal stability.

Flame-retardant resin compositions comprising thermoplastic polyesters using organic halide compounds as the main ingredient have involved a problem in their thermal stability. Particularly, flame-retardant resin compositions composed of polyethylene terephthalate excellent in heat-resistance have a relatively high molding temperature and exhibit remarkable heat degradation upon molding. A flame retardant resin composition comprising a thermoplastic polyester having an improved thermal stability is disclosed, for example, in JP-A-195142/82. In this composition, the surface of antimony trioxide added for providing flame-retarding property is treated with an alkoxysilane to form a cover which is inactive to the hydrolysis of the thermoplastic polyester thereby improving the thermostability. However, as can be seen from the examples of JP-A-195142/82, the mechanical strength, particularly, the tensile strength of the molding product is relatively low and not yet sufficiently satisfactory in specific uses. JP-A-2357/82 describes that covered antimony oxide has no thermal stability of commercial value. JP-A-2357/82 describes a specific composition excellent in the thermal stability. According to the specification thereof, when a particular substance for improving the crystallizing rate and an antimonate salt of a metal belonging to group I, II and VIII of the Periodic Table are used together in a flame-retardant, they do not give adverse effects on the thermal stability and improve the flame-retardancy. Generally, since crystallization stimulators tend to reduce the mechanical strength of the resin composition, their use is limited. Further, the possible range of applying this technique is limited since the effect can only be obtained in the combined use of a specific crystallization stimulator and an antimonate salt. Accordingly, a flame-retardant resin composition composed of a thermoplastic polyester having a relatively high mechanical strength and, at the same time, excellent in the thermal stability has been demanded.

EP-A-65 777 describes a flame-retardant resin composition comprising

(A) at least one polymer resin consisting of thermoplastic polyesters or thermoplastic polycarbonates, per 100 parts by weight of the polymer resin,

(B) 0.1 to 30 parts by weight, as the weight of the halogen element, of an organic halogen compound and

(C) 0.1 to 20 parts by weight, as the weight of the antimony element of antimony trioxide treated with an alkoxy silane compound.

US-A-4 100 075 relates to finely divided particulate inorganic antimony compounds which are surface-modified with up to about 5% by weight of an organosilane having the formula

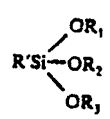

wherein $R_1$, $R_2$ and $R_3$ are each independently hydrogen, lower alkyl, lower alkenyl, alkoxyalkyl aryl, lower alkylaryl, or lower arylakyl groups and R' is an organo functional group as described.

An object of the present invention is to provide a flame-retardant resin composition comprising a thermoplastic polyester having a relatively high mechanical strength and excellent thermal stability in view of the foregoing situations.

The object of the present invention can be attained in accordance with the present invention by a flame-retardant resin composition comprising the following ingredients (a) to (d):

(a) a thermoplastic polyester,

(b) a flame-retardant containing an organic halide compound in an amount of 5 to 50 parts by weight based on 100 parts by weight of the thermoplastic polyester, and

(c) an alkoxy silane compound of the general formula (B)

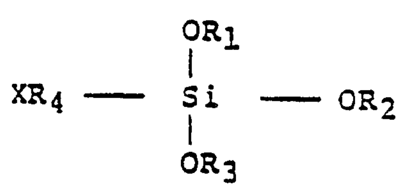

(B)

wherein each of $R_1$, $R_2$, $R_3$ and $R_4$ is an alkyl group having 1 to 5 carbon atoms or $-C_mH_{2m}-O-C_nH_{2n+1}$ wherein $m+n$ is an integer of 5 or less, and X represents $-CH=CH_2$, $-COOCH_3C=CH_2$, $-NH_2$, $-NHC_2H_4NH_2$, $-NHCONH_2$ or

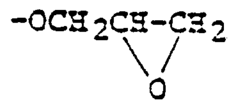

in an amount of 0.03 to 2.0% by weight of the flame retardant resin

(d) and an antimony compound in an amount of 1 to 20 parts by weight based on 100 parts by weight of the thermoplastic polyester.

The thermoplastic polyester of the present invention is a saturated linear polyester prepared by reacting a terephthalic acid or a derivative capable of forming esters thereof as an acid ingredient, with a glycol having 2 to 10 carbon atoms or a derivative capable of forming esters thereof as a glycol ingredient. Specifically, there can be mentioned a polyethylene terephthalate, a polypropylene terephthalate, a polybutylene terephthalate, a polytetramethylene terephthalate and a polyhexamethylene terephthalate. These thermoplastic polyesters may be used alone or in admixture of two or more of them. Further, the thermoplastic polyester may contain up to 50% by weight of other ingredients, for example, a diethylene glycol, a polyalkylene oxide, an aromatic diol, etc. Among them, those block copolymers comprising from 1 to 20 parts by weight of a diol represented by the following general formula (A) and from 80 to 99 parts by weight of polyethylene terephthalate are particularly preferred:

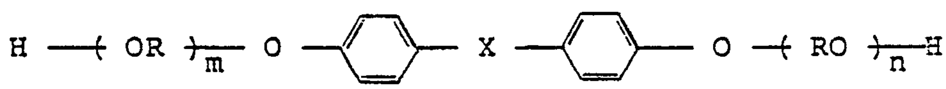

(A)

wherein X represents a divalent connecting group such as a $-C(CH_3)2-$ group, $-SO_2-$ group, -CO- group or -O- group; R represents an alkylene group having 1 to 4 carbon atoms; and n and m each represents an integer from 1 to 15. The intrinsic viscosity of the thermoplastic polyester when measured at 25°C in a mixed solvent of phenol and 1,1,2,2-tetrachloroethane (1 : 1 weight ratio) is preferably from 0.4 to 1.2, more preferably, from 0.5 to 1.0 and most preferably, from 0.55 to 0.70.

The flame-retardants referred to in the present invention are those comprising organic halide compound as a main ingredient and an antimony compound. The organic halide compound may include, specifically, tetrabromobisphenol A and oligomers thereof, decabromobiphenyloxide, octabromobiphenyloxide, poly-(dibromophenyleneoxide), polystyrene bromide, a condensate of 2 mol of tetrachlorocyclopentadiene and 1 mol of cyclooctadiene, poly(pentabromobenzyl acrylate), a condensate of tetrabromobisphenol A, cyanuric chloride and tribromophenol, hexabromocyclododecane and a condensate of tribromophenol and glycidol and the like. Among them, aromatic halide compounds in which halogen atoms are directly coupled to the aromatic ring are preferably used.

As the halogen, bromine or chlorine is preferred. The organic halide compound may be used in a sufficient amount for providing the composition with flame-retardancy, usually, in an amount of from 5 to 50 parts by weight and, preferably, from 10 to 30 parts by weight based on 100 parts by weight of the thermoplastic polyester. The antimony compound used includes, for example, antimony trioxide, antimony pentoxide, sodium antimonate, etc. Sodium antimonate is excellent for improving the thermal stability of the flame-retardant resin composition comprising a thermoplastic polyester. Particularly, sodium antimonate baked at a temperature of not lower than 600°C is preferred. Above all, sodium antimonate having an average particle size of from 2 to 10 µm baked at a temperature of not lower than 600°C is most preferable. The amount of the antimony compound used is 1 to 20 parts by weight, preferably, from 1 to 15 parts by weight and, particularly, from 2 to 10 parts by weight based on 100 parts by weight of the thermoplastic polyester.

The alkoxy silane compound is a compound represented by the following general formula (B):

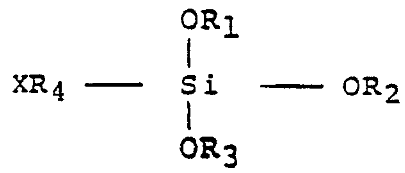 (B)

wherein each of $R_1$, $R_2$, $R_3$ and $R_4$ is an alkyl group having 1 to 5 carbon atoms or $-C_mH_{2m}-O-C_nH_{2n+1}$ wherein $m+n$ is an integer of 5 or less, and X represents $-CH=CH_2$, $-COOCH_3C=CH_2$, $-NH_2$, $-NHC_2H_4NH_2$, $-NHCONH_2$ or

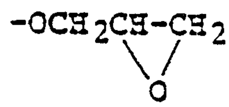

The compounds in which X contains an amino group or an epoxy group are referred to as an amino silane compound or an epoxy silane compound, respectively. The amount of the alkoxy silane compound to be mixed is preferably from 0.03 to 2.0% by weight, more preferably, from 0.05 to 1% by weight and, most preferably, from 0.1 to 0.5% by weight of the flame-retardant resin.

Various methods may be employed for mixing the alkoxy silane compound and other ingredients in the flame-retardant resin composition. For the most simple and general method, the alkoxy silane compound may be added while mixing the thermoplastic polyester and the flame-retardant in a ribbon blender. The alkoxy silane compound has been used as surface treating agent for glass fibers. The thermally stable composition according to the present invention cannot be obtained by merely mixing the glass fibers surface-treated with the alkoxy silane compound, etc., with a flame-retardant resin composition.

In the flame-retardant resin composition according to the present invention, 1 to 10 parts by weight of a copolymer of ethylene and $\alpha$ ,$\beta$-unsaturated carboxylic acid in which 5 to 50 mol% of carboxylic groups contained in the copolymer are neutralized with an alkali metal may be blended based on 100 parts by weight of the thermoplastic polyester. The copolymers are disclosed in JP-B-26225/70, JP-A-3839/71, 55451/81, for example, copolymers of ethylene and $\alpha$,$\beta$-unsaturated carboxylic acid such as acrylic acid, methacrylic acid, maleic acid or like, wherein the olefin content is at least 50% by weight and 5 to 50 mol% of the carboxylic groups in the copolymer are neutralized with an alkali metal salt. A preferred alkali metal is sodium.

The flame-retardant resin composition according to the present invention may further be blended with up to 200 parts by weight of organic or inorganic reinforcing substance or filler, if required, based on 100 parts by weight of the thermoplastic polyester. If the blending amount exceeds 200 parts by weight, molding of the composition becomes difficult and the mechanical strength of the composition is reduced as well. A preferred blending amount is less than 150 parts by weight. The organic or inorganic reinforcing substance or filler are those materials that are added for improving the properties of the molded flame-retardant resin composition in order to, for example, enhance strength and elasticity, for protecting bend, minimizing dimensional change, etc. Specifically, they include fiberous reinforcing material such as glass fibers, carbon fibers, asbestos, aromatic polyamide fibers, silicon carbide fibers, potassium titanate fibers and mineral fibers, as well as calcium carbonate, magnesium carbonate, calcined clay, graphite, mica, talc, glass beads, metal powder, fluoro resin powder and the like. They are used alone or in admixture of two or more of them.

In the flame-retardant resin composition according to the present invention, those additives usually employed for thermoplastic flame-retardant polyester resins, for example, anti-oxidants, coloring agents, crystallization stimulators, plasticizers, resins other than polyester and the like may be blended in addition to the above-mentioned ingredients.

The composition after mixing the thermoplastic polyester, flame-retardant, alkoxy silane compound and the like can further be formed into a uniform and easily usable flame-retardant composition when further subjected to mixing under melting. The mixing under melting is conveniently carried out by using an extruder.

The flame-retardant resin compositions of the present invention are particularly advantageous when used as various applications,such as electronic parts, electric parts, parts for office automation devices, automobile parts, and the like.

The present invention will now be described more specifically with referring to Examples and Comparative Examples, but it should be noted that the present invention is no way limited only thereto. In the Examples and Comparative Examples, "parts" and "%" are by weight.

EXAMPLE 1

While stirring 4.6 kg of polyethylene terephthalate having an intrinsic viscosity of 0.63 measured at 25° C in a mixed solvent of phenol and 1,1,2,2-tetrachloroethane (1 : 1 weight ratio) and dried to a water content of less than 0.03%, 1.4 kg of polystyrene bromide PYROCHECK 68PB® (trade name of products manufactured by Ferro Corporation), 0.3 kg of sodium antimonate calcined at 700° C, 0.5 kg of a copolymer of ethylene and unsaturated carboxylic acid HI-MIRAN 1707® (trade name of products manufactured by Mitsui-Du Pont Polychemical Co.), 0.2 kg of erucic acid amide, 50 g of a stabilizer IRGANOX 1010® (trade name of products manufactured by Ciba Geigy Limited), 50 g of a stabilizer SEANOX 412S® (trade name of products manufactured by Shipro Kasei Kaisha Co.) in a ribbon blender, 15 g of γ-aminopropyltriethoxy silane (A-1100 manufactured by Nippon Unicar Co.) were added and the stirring was continued further for 5 minutes.

The blend was kneaded under melting by using a biaxial extruder PCM-45® manufactured by Ikegai Tekko Co., to obtain a pellet-like resin composition. Glass fibers (Glasslon 03MJ-486A manufactured by Asahi Fiber Glass Co.) were added in an amount of 30% of the composition at the midway of the biaxial extruder.

As the temperature condition for the extrusion, a temperature gradient of from 200 to 260° C was created from the hopper side toward the dice side.

Other conditions were selected as usual for enabling stable extrusion operation. Then, the pelletized resin was dried at 140° C for 4 hours and then test specimens were prepared by using an injection molding machine (IS-50A manufactured by Toshiba Kikai Co.).

As an evaluation method for the thermal stability, mechanical strength was examined at two temperature levels i.e., at normal temperature (270° C) and higher temperature (290° C). The injection molding conditions included a mold temperature of 80° C, cooling time of 30 sec, primary injecting pressure of 495 kg/cm$^2$ (4.86•10$^7$Pa), secondary injection pressure of 360 kg/cm$^2$ (3.53•10$^7$Pa) and injection time of 7 seconds. The thermal stability was evaluated by comparing the tensile strength of the products molded at 270° C and 290° C. The results are shown in Table 1.

The molded products satisfied the requirements of U.L. (Underwriters Laboratories) Standard 94 as V-0 using a specimen of 1/32 inch (0.794 mm) in thickness.

EXAMPLE 2

The procedure of Example 1 was repeated except that 20 g of γ-glycidyloxy propyltrimethoxy silane (A-187, manufactured by Nippon Unicar Co.) were used instead of γ-aminopropyl triethoxy silane. The results are shown in Table 1.

The molded products satisfied the requirements of U.L. (Underwriters Laboratories) Standard 94 as V-0 using a specimen of 1/32 inch (0.794 mm) in thickness.

COMPARATIVE EXAMPLE 1

In the same manner as in Example 1, a composition without adding γ-aminopropyltriethoxy silane was prepared and evaluated. Other conditions were the same as those in Example 1. The results are shown in Table 1. The molded products also satified the requirements of U.L. Standard 94 as V-0.

COMPARATIVE EXAMPLE 2

The procedure of Comparative Example 1 was repeated except that glass fibers prepared according to the following procedure were used. The results are shown in Table 1.

Preparation of Glass Fibers

5.0 kg of GLASSLON 03MJ-486A® were charged in a ribbon blender, and a mixture of 25 g of distilled water, 225 g of methanol and 25 g of A-1100® mixed thoroughly was added under stirring and the stirring was further continued for 5 minutes. The resulting mixture was dried at 130° C for 2 hours.

Table 1

| | Example 1 | Example 2 | Comparative Example 1 | Comparative Example 2 |
|---|---|---|---|---|
| (1) Tensile strength molded at 270°C ($kg/cm^2$)[$x10^8$Pa] | 1540 [1.511] | 1550 [1.521] | 1350 [1.324] | 1460 [1.432] |
| (2) Tensile strength molded at 290°C ($kg/cm^2$)[$x10^8$Pa] | 1510 [1.481] | 1540 [1.511] | 1350 [1.324] | 1370 [1.344] |
| (2)x100/(1) (%) | 98.1 | 99.4 | 100 | 93.8 |

Note: The tensile strength was measured according to ASTM D-638.

As is apparent from the results shown in Table 1, the flame-retardant resin composition according to this invention had high strength and was excellent in thermal stability. The molded products also satisfied the requirements of U.L. Standard 94 as V-0.

EXAMPLE 3

The procedure of Example 2 was repeated except that 0.3 kg of antimony trioxide (PATOX-H manufactured by Nippon Seiko Co.) was used instead of sodium antimonate. The results are shown in Table 2.

The molded products satisfied the requirements of U.L. (Underwriters Laboratories) Standard 94 as V-0 using a specimen of 1/32 inch (0.794 mm) in thickness.

EXAMPLE 4

The procedure of Example 1 was repeated except that 1.3 kg of poly-pentabromobenzyl acrylate (FR-1025 manufactured by Ded C. Bromine Co.) was used instead of PYROCHECK 68PB®. The results are shown in Table 2 below.

The molded products satisfied the requirements of U.L. (Underwriters Laboratories) Standard 94 as V-0 using a specimen of 1/32 inch (0.794 mm) in thickness.

COMPARATIVE EXAMPLE 3

The procedure of Comparative Example 2 was repeated except that PATOX-H® was used instead of sodium antimonate and FR-1025® instead of PYROCHECK 68PB®, respectively. The results are shown in Table 1 below.

Table 2

| | Example 3 | Example 4 | Comparative Example 3 |
|---|---|---|---|
| (1) Tensile strength molded at 270°C ($kg/cm^2$)[$x10^8$Pa] | 1530 [1.501] | 1560 [1.530] | 1460 [1.432] |
| (2) Tensile strength molded at 290°C ($kg/cm^2$)[$x10^8$Pa] | 1500 [1.472] | 1520 [1.491] | 1210 [1.187] |
| (2)x100/(1) (%) | 98.0 | 97.4 | 82.9 |

The molded products also satisfied the requirements of U.L. Standard 94 as V-0.

EXAMPLE 5

The procedure of Example 2 was repeated except that polyethylene terephthalate having an intrinsic viscosity of 0.60, in which an ethylene oxide addition polymer of bisphenol A (bisphenol A to ethylene oxide is 1 : 17; average molecular weight 1000) was block copolymerized by 5% was used instead of polyethylene terephthalate having an intrinsic viscosity of 0.63 stated in Example 1. Other conditions were the same as in Example 2.

| | |
|---|---|
| (1) Tensile strength molded at 270 °C ($kg/cm^2$)[$x10^8$ Pa] | 1540 [1.511] |
| (2) Tensile strength molded at 290 °C ($kg/cm^2$)[$x10^8$ Pa] | 1530 [1.501] |
| (2) x 100/(1) (%) | 99.4 |

The molded products satisfied the requirements of U.L. (Underwriters Laboratories) Standard 94 as V-0 using a specimen of 1/32 inch (0.794 mm) in thickness.

EXAMPLE 6

A mixture of 5.3 kg of polyethylene terephthalate having an intrinsic viscosity of 0.58 when measured at 25 °C in a mixed solvent of phenol and 1,1,2,2-tetrachloroethane (1:1 weight ratio) and being dried to a water content of less than 0.03%, 1.4 kg of polydibromophenylene oxide (PO-64P manufactured by Great Lakes Chemical Corporation), 0.3 kg of sodium antimonate, 50 g of IRGANOX 1010® 50 g of SEANOX 412S®, 10 g of A-187® and GLASSLON 03MJ-486A® in an amount of 30% of the composition was processed in the same manner as in Example 1 to obtain a test piece. The results are shown in Table 3 below.

The molded products satisfied the requirements of U.L. (Underwriters Laboratories) Standard 94 as V-0 using a specimen of 1/32 inch (0.794 mm) in thickness.

EXAMPLE 7

The procedure of Example 6 was repeated except that the polyethylene block copolymer used in Example 5 was used instead of the polyethylene terephthalate of Example 6. The results are shown in Table 3 below.

The molded products satisfied the requirements of U.L. (Underwriters Laboratories) Standard 94 as V-0 using a specimen of 1/32 inch (0.794 mm) in thickness.

EXAMPLE 8

A resin composition without adding the glass fibers was prepared in the same manner as in Example 2. The results are shown in Table 3 below.

The molded products satisfied the requirements of U.L. (Underwriters Laboratories) Standard 94 as V-0 using a specimen of 1/32 inch (0.794 mm) in thickness.

COMPARATIVE EXAMPLE 4

A resin composition without adding A-187® was prepared in the same manner as in Example 8. The results are shown in Table 3 below.

Table 3

| | Example 6 | Example 7 | Example 8 | Comparative Example 4 |
|---|---|---|---|---|
| (1) Tensile strength molded at 270°C (kg/cm²)[x$10^8$Pa] | 1560 [1.530] | 1570 [1.540] | 678 [0.665] | 675 [0.662] |
| (2) Tensile strength molded at 290°C (kg/cm²)[x$10^8$Pa] | 1560 [1.530] | 1560 [1.530] | 680 [0.667] | 573 [0.562] |
| (2)x100/(1) (%) | 100 | 99.4 | 100.3 | 84.9 |

As has been described above according to the present invention, a flame retardant resin composition having high strength and excellent in the thermal stability can be provided. The mold products also satisfied the requirements of U.L. Standard 94 as V-0.

## Claims

1. A flame-retardant resin composition which comprises a thermoplastic polyester; a flame retardant containing an organic halide compound in an amount of 5 to 50 parts by weight based on 100 parts by weight of the thermoplastic polyester and an alkoxysilane compound of the general formula (B)

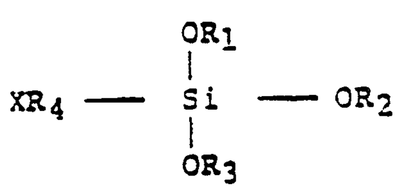

(B)

wherein each of $R_1$, $R_2$, $R_3$ and $R_4$ is an aklyl group having 1 to S carbon atoms or $-C_mH_{2m}-O-C_nH_{2n+1}$ wherein m+n is an integer of 5 or less, and X represents $-CH=CH_2$, $-COOCH_3C=CH_2$, $-NH_2$, $-NHC_2H_4NH_2$, $-NHCONH_2$ or

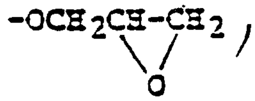

in an amount of 0.03 to 2.0% by weight of the flame retardant resin and an antimony compound in an amount of 1 to 20 parts by weight based on 100 parts by weight of the thermoplastic polyester.

2. The flame-retardant resin composition as in claim 1, wherein the alkoxysilane compound is an aminosilane compound and/or an epoxysilane compound.

3. The flame-retardant resin composition as in claim 1 or 2, wherein the amount of the alkoxysilane compound is from 0.05 to 1.0% by weight based on the total amount of the flame-retardant resin composition.

4. The flame-retardant resin composition as in claim 1 to 3, wherein the flame-retardant comprises an aromatic compound containing halogen atoms directly bonded to the aromatic ring.

5. The flame-retardant resin composition as in claim 4, wherein the antimony compound is an antimonate salt of a metal belonging to Group I, II and VIII of the Periodic Table.

6. The flame-retardant resin composition as in claim 5, wherein the antimonate salt is sodium antimonate and/or potassium antimonate.

7. The flame-retardant resin composition as in claim 4 to 6, wherein the amount of the aromatic compound is from 5 to 50 parts by weight and the amount of the antimony compound is from 1 to 15 parts by weight respectively based on 100 parts by weight of the thermoplastic polyester.

8. The flame-retardant resin composition as in claim 1 to 7, wherein from 1 to 10 parts by weight of a copolymer comprising ethylene and an $\alpha,\beta$-unsaturated carboxylic acid in which from 5 to 50 mol% of the carboxylic groups contained in said copolymer are neutralized with an alkali metal are contained based on 100 parts by weight of the thermoplastic polyester.

9. The flame-retardant resin composition as in claim 1, wherein the thermoplastic polyester is polyethylene terephthalate.

10. The flame-retardant resin composition as in claim 1, wherein the thermoplastic polyester is a block copolymer of polyethylene terephthalate and a compound represented by the following general formula (A):

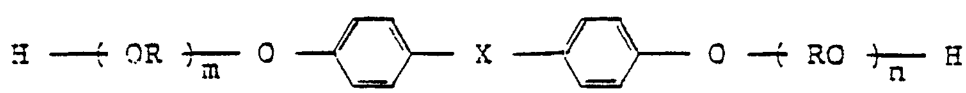

(A)

wherein X represents one of the divalent connecting groups $-C(CH_3)_2-$, $-SO_2-$ -CO-, or -O-;
R represents an alkylene group having 1 to 4 carbon atoms; and n and m each represents an integer from 1 to 15;

and the content of the segments represented by the general formula (A) in said copolymer is from 1 to 20 parts by weight.

11. The flame-retardant resin composition as in claim 1 to 10, which contains less than 200 parts by weight of organic and/or inorganic reinforcing substances and/or filler based on 100 parts by weight of the thermoplastic polyester.

**Revendications**

1. Une composition de résine ignifuge qui comprend un polyester thermoplastique ; un agent ignifugeant contenant un halogénure organique, en quantité de 5 à 50 parties en poids pour 100 parties en poids du polyester thermoplastique ; et un alcoxysilane de formule générale (B)

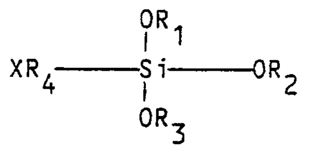

(B)

dans laquelle $R_1$, $R_2$, $R_3$ et $R_4$ sont chacun un groupe alkyle en $C_1$-$C_5$ ou un groupe de formule $-C_mH_{2m}-OC_nH_{2n+1}$ dans laquelle la somme m+n est un entier égal ou inférieur à 5 et X représente $-CH=CH_2$, $-COOCH_3C=CH_2$, $-NH_2$, $-NHC_2H_4NH_2$, $-NHCONH_2$ ou

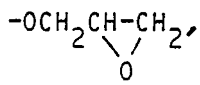

en quantité de 0,03 à 2,0 % en poids par rapport à la résine ignifuge
et un composé d'antimoine en quantité de 1 à 20 parties en poids pour 100 parties en poids du polyester thermoplastique.

2. La composition de résine ignifuge selon la revendication 1, dans laquelle l'alcoxysilane est un aminosilane et/ou un époxysilane.

3. La composition de résine ignifuge selon la revendication 1 ou 2, dans laquelle la quantité de l'alcoxysilane est de 0,05 à 1,0 % en poids par rapport à la quantité totale de la composition de résine ignifuge.

4. La composition de résine ignifuge selon les revendications 1 à 3, dans laquelle l'agent ignifugeant comprend un composé aromatique contenant des atomes d'halogène directement liés au noyau aromatique.

5. La composition de résine ignifuge selon la revendication 4, dans laquelle le composé d'antimoine est un sel antimoniate d'un métal appartenant aux groupes I, II et VIII de la Classification Périodique.

6. La composition de résine ignifuge selon la revendication 5, dans laquelle le sel antimoniate est l'antimoniate de sodium et/ou l'antimoniate de potassium.

7. La composition de résine ignifuge selon les revendications 4 à 6, dans laquelle la quantité du composé aromatique est de 5 à 50 parties en poids et la quantité du composé d'antimoine est de 1 à 15 parties en poids, respectivement, pour 100 parties en poids du polyester thermoplastique.

8. La composition de résine ignifuge selon les revendications 1 à 7, qui contient 1 à 10 parties en poids, pour 100 parties en poids du polyester thermoplastique, d'un copolymère contenant de l'éthylène et un acide carboxylique $\alpha,\beta$-insaturé dans lequel 5 à 50 mol% des groupes carboxyliques contenus dans ledit copolymère sont neutralisés par un métal alcalin.

9. La composition de résine ignifuge selon la revendication 1, dans laquelle le polyester thermoplastique est le polytéréphtalate d'éthylène.

10. La composition de résine ignifuge selon la revendication 1, dans laquelle le polyester thermoplastique est un copolymère séquencé de polytéréphtalate d'éthylène et d'un composé représenté par la formule générale (A) suivante :

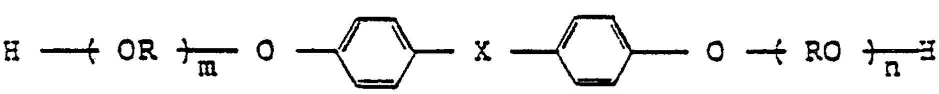

(A)

dans laquelle X représente un chaînon de liaison divalent choisi parmi $-C(CH_3)_2-$, $-SO_2-$, $-CO-$ et $-O-$ ; R représente un groupe alkylène en $C_1$-$C_4$ ; et m et n représentent chacun un entier de 1 à 15 ;

et la teneur dudit copolymère en segments représentés par la formule générale (A) est de 1 à 20 parties en poids.

11. La composition de résine ignifuge selon l'une des revendications 1 à 10, qui contient moins de 200 parties en poids de matières de renforcement et/ou charges organiques et/ou inorganiques pour 100 parties en poids du polyester thermoplastique.

**Patentansprüche**

1. Flammhemmende Harzzusammensetzung, umfassend einen thermoplastischen Polyester, einen Flammenhemmstoff enthaltend eine organische Halogenverbindung in einer Menge von 5 bis 50 Gew.-Teilen bezogen auf 100 Gewichtsteile des thermoplastischen Polyesters und eine Alkoxysilan-Verbindung der allgemeinen Formel (B),

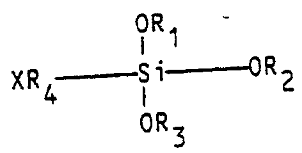

(B)

in der jeder der Reste $R_1$, $R_2$, $R_3$ und $R_4$ einen Alkylrest mit 1 bis 5 Kohlenstoffatomen oder den Rest $-C_mH_2m-O-C_nH_{2n+1}$ bedeutet, wobei $m+n$ eine ganze Zahl von 5 oder Weniger ist, und X die Reste $-CH=CH_2$, $-COOCH_3C=CH_2$, $-NH_2$, $-NHC_2H_4NH_2$, $-NHCONH_2$ oder

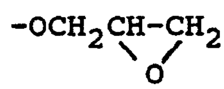

darstellt, in einer Menge von 0,03 bis 2,0 Gew.-%, bezogen auf das flammhemmende Harz,
und eine Antimonverbindung in einer Menge von 1 bis 20 Gew.-Teilen, bezogen auf 100 Gew.-Teile des thermoplastischen Polyesters.

2. Flammhemmende Harzzusammensetzung nach Anspruch 1, wobei die Alkoxysilan-Verbindung eine Aminosilan-Verbindung und/oder eine Epoxysilan-Verbindung ist.

3. Flammhemmende Harzzusammensetzung nach Anspruch 1 oder 2, wobei die Menge der Alkoxysilan-Verbindung 0,05 bis 1,0 Gew.-%, bezogen auf die Gesamtmenge der flammhemmenden Harzzusammensetzung, beträgt.

4. Flammhemmende Harzzusammensetzung nach den Ansprüchen 1 bis 3, wobei der Flammenhemmstoff eine aromatische Verbindung umfaßt, die direkt an den aromatischen Ring gebundene Halogenatome enthält.

5. Flammhemmende Harzzusammensetzung nach Anspruch 4, wobei die Antimon-Verbindung ein Antimonat-Salz der Metalle der Gruppen I, II und VIII des Periodensystems ist.

6. Flammhemmende Harzzusammensetzung nach Anspruch 5, wobei das Antimonat-Salz Natriumantimonat und/oder Kaliumantimonat ist.

7. Flammhemmende Harzzusammensetzung nach den Ansprüchen 4 bis 6, wobei die Menge der aromatischen Verbindung 5 bis 50 Gew.-Teile und die Menge der Antimon-Verbindung 1 bis 15 Gew.-Teile, jeweils bezogen auf 100 Gew.-Teile des thermoplastischen Polyesters, beträgt.

8. Flammhemmende Harzzusammensetzung nach den Ansprüchen 1 bis 7, wobei 1 bis 10 Gew.-Teile eines Copolymers, umfassend Ethylen und eine $\alpha,\beta$-ungesättigte Carbonsäure, in dem 5 bis 50 Mol-% der im Copolymer enthaltenen Carbonsäuregruppen mit einem Alkalimetall neutralisiert sind, bezogen auf 100 Gew.-Teile des thermoplastischen Polyesters,enthalten sind.

9. Flammhemmende Harzzusammensetzung nach Anspruch 1, wobei der thermoplastische Polyester Polyethylenterephthalat ist.

10. Flammhemmende Harzzusammensetzung nach Anspruch 1, wobei der thermoplastische Polyester ein Block-Copolymer aus Polyethylenterephthalat und einer Verbindung der folgenden allgemeinen Formel (A) ist,

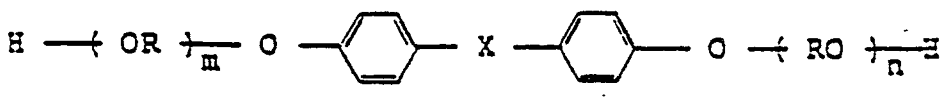

(A)

in der X eine der divalenten Verbindungsgruppen $-C(CH_3)_2-$, $-SO_2-$, -CO- oder -O- darstellt, R einen Alkylenrest mit 1 bis 4 Kohlenstoffatomen darstellt und n und m jeweils eine ganze Zahl von 1 bis 15 darstellen; und der Gehalt der durch die allgemeine Formel (A) dargestellten Abschnitte in dem Copolymer 1 bis 20 Gew.-% beträgt.

11. Flammhemmende Harzzusammensetzung nach den Ansprüchen 1 bis 10, welche weniger als 200 Gew.-Teile an organischen und/oder anorganischen Verstärkungssubstanzen und/oder Füllmittel, bezogen auf 100 Gew.-Teile des thermoplastischen Polyesters, enthält.